# EUROPEAN PATENT SPECIFICATION

(11) **EP 0 434 273 B1**
(45) Date of publication and mention of the grant of the patent: **20.08.1997**
(21) Application number: 90313388.2
(22) Date of filing: 10.12.1990
(51) Int. Cl.: H01L 31/0216, G03C 7/12

(54) **Electromagnetic radiation filter elements and methods of fabrication**
Filter für elektromagnetische Strahlung und Herstellungsverfahren
Elément de filtrage de radiation électromagnétique et méthode de fabrication

(30) Priority: 22.12.1989 US 454887
(43) Date of publication of application: 26.06.1991
(73) Proprietor: TEXAS INSTRUMENTS INCORPORATED, Dallas Texas 75265 (US)
(72) Inventor: Hynecek, Jaroslav, Richardson, Texas 75081 (US)
(74) Representative: Legg, Cyrus James Grahame

(56) References cited:
- WO-A-88/05180
- US-A- 4 168 448
- US-A- 4 239 842
- US-A- 4 393 121
- US-A- 4 419 425
- US-A- 4 618 565
- US-A- 4 721 999
- US-A- 4 745 327
- US-A- 4 808 501
- PATENT ABSTRACTS OF JAPAN vol. 8, no. 237 (P-310) 30 October 1984 & JP-A-59 113 404 (SANYO DENKI KK) 30 June 1984
- SOLID STATE TECHNOLOGY, vol.31, no.5, May 1988, WASHINGTON US pages 223 - 226 W. J, LATHAM ET AL. 'COLOR FILTERS FROM DYED POLYIMIDES'

## Description

### TECHNICAL FIELD OF THE INVENTION

The present invention relates in general to filter elements and methods for their fabrication, and in particular to electromagnetic radiation filter elements and methods for their fabrication.

### BACKGROUND OF THE INVENTION

Electromagnetic filter elements play an important part in imaging using charge coupled devices. Of particular importance are color filter elements transmitting electromagnetic radiation in the optical portion of the electromagnetic spectrum. When filter elements are used for color imaging using charge coupled device image sensors, it is critical that the edges of such filter elements be sharp, i.e. the transition regions should be narrow, so that the filter closely matches its corresponding sensor element. The filter element also must be capable of being formed directly at the face of the semiconductor for optical coupling efficiency. Much work has been done in an attempt to develop techniques to create sharp edge filter elements directly at the face of a semiconductor.

One means of creating a color filter is through the use of gelatin in which a dye has been suspended. The dye, selected for its ability to transfer electromagnetic radiation of the desired wavelength and block at least some electromagnetic radiation of undesirable wavelengths is held in an aqueous or organic solvent. A layer of gelatin is spin-coated on the face of a semiconductor and patterned through standard photolithography. The workpiece is dipped in the dye solution such that the dye is transferred to the gelatin. After the process of transferring the dye into the gelatin on the workpiece, the gelatin is baked so that the dye is cross-linked into the gelatin at the semiconductor face. This process can be repeated, using separation layers to prevent dye diffusion between filter layers and to form several filter elements at the semiconductor face. For example, the process can be repeated three times to make adjacent red, green and blue filter elements.

The method of transferring dye onto a gelatin-patterned wafer is a complicated and lengthy process with low yield. To achieve uniformity across the whole wafer in production is difficult because of the complexity of the process and the inherent nonuniformity of the dye transfer mechanism. There is also difficulty in assuring sufficient separation of layers during the formation process in order to prevent dye diffusion between filter elements. Finally, the dye/gelatin composite has a low long term stability, especially when it is used in applications exposing the filter element to ultraviolet radiation.

Another, more recent approach, uses a photosensitive polyimide polymer with dye incorporated in it. This approach is described in Latham and Hawley, "Color Filters From Dyed Polyimides", Solid State Technology, May, 1988. The polymer/dye composite is deposited on a face of the semiconductor device, exposed and developed like a standard photoresist, and then cross-linked by baking. As with the previously discussed approach, the process can be repeated to create a plurality of filter elements of varying colors.

This second approach also has disadvantages. First, the available polyimide is a negative type. Therefore, after exposure and development during photolithography, the exposed area stays on the chip. Second, during the development process, dye is leached from the newly formed layers of the polymer/dye composite. Third, during the exposure and development process, large exposures are necessary because the dye itself absorbs a portion of the light energy. Finally, and most importantly, the transition regions at the edges and sidewalls of the filter formations are wide, exceeding several microns. Wide transition regions make it difficult to match filter elements with their corresponding receptor elements and to precisely overlap adjacent filter regions, and represent a scaling barrier.

As has been seen, the two above described methods for forming color filter elements at a semiconductor face each have significant disadvantages. A need has thus arisen to develop a less complicated fabrication process for forming color filter elements at the face of a semiconductor layer, the filter elements having sharp edges and transmitting electromagnetic radiation of a predetermined transmission band.

The disclosures of some earlier patents and applications for patents are summarised below:

US-A-4 239 842 discloses a semiconductor imaging device overlaid by a layer of transparent polyester material bearing patterns of regions of dyes of several different colours which filter the light impinging on the device. This filter layer is made by depositing a layer of transparent polyester over the semiconductor. A layer of photoresist is deposited over that and is patterned to form a mask. The device is then brought into contact with heated dye which diffuses through windows in the photoresist layer into the polyester layer. Regions in the polyester layer of other colours are produced by repeating the masking and dyeing steps.

The entry in Patent Abstracts of Japan for JP-A-59113404 discloses forming a filter over an imaging substrate by depositing a layer of coloured resist and patterning that layer. Regions of other colours are formed on the same substrate by depositing and patterning layers of resist of other colours.

WO-A-88/05180 discloses forming a filter for a microelectronic device by spinning or spraying a layer of dye bearing resin either directly onto the microelectronic device or onto a glass substrate which is later bonded to the microelectronic device. A mask layer over the resin layer is prepared by photolithography and the layer of resin is patterned by wet or dry etching. For wet etching the mask developer is used to remove the unwanted photoresist and dye bearing resin at the same time. Regions of resin bearing other colour dyes are added by repeating the process.

US-A-4 393 129 discloses an improved method of developing PMMA electron or X-ray resist which results in the patterned resist being free of cracks.

### SUMMARY OF THE INVENTION

The present invention provides an electromagnetic radiation filter element comprising:
a first radiation-transmitting solid formed on a supporting structure, said supporting structure being operable to receive radiation as filtered by said solid, said first radiation-transmitting solid being a particle beam resist, a bottom face of said solid being adjacent said supporting structure, a top face of said solid being remote from said supporting structure;
a first solvent dye suspended in said solid for filtering radiation of first wavelengths;
sidewalls of said first solid extending from said top face to said bottom face, a slope of said sidewalls being such that, at each sidewall, said bottom face extends laterally outwardly beyond said top face by an amount no greater than two micrometer;
a planarization layer over said first solid;
a second radiation-transmitting solid of a particle beam resist material over said planarization layer; and
a second solvent dye suspended in said second solid for filtering radiation of second wavelengths.

The present invention also provides a method for fabricating an electromagnetic filter comprising:
forming a first layer of particle beam resist with a first solvent dye suspended therein;
patterning the first particle beam resist layer by exposure to particle bombardment;
forming a planarization layer over the first particle beam resist layer; and
forming a second layer of particle beam resist with a second solvent dye suspended therein.

In a preferred embodiment, a positive acting system using particle bombardment (either electrons or ions, but not merely electromagnetic radiation) is used to form the filter pattern. The surface of a supporting device, such as a semiconductor sensor, is prepared with a layer of adhesion promoter. The adhesion promoter planarizes the surface and provides protection from particle bombardment during subsequent filter fabrication. A dye is suspended in a base material to form a dye suspension. The dye suspension is then deposited in a layer across the surface of the support device. A patterned mask of photoresist is formed across the layer of dye suspension material to form a masked surface. Particle bombardment is directed at a substantially perpendicular angle towards the masked surface. The particle bombardment renders those areas of the dye suspension left exposed by the mask, including the suspended dye, soluble to developing agents. The exposed areas are chemically removed in the development process and the photoresist mask is stripped off leaving the desired pattern of filter elements.

In a second embodiment, the filter elements are formed using a negative acting system using particle bombardment. The dye suspension is again deposited in a layer across the surface of a supporting structure. A patterned mask of photoresist is formed over the dye suspension layer to form a masked surface. As before, the masked surface is then exposed to particle bombardment incident at a substantially perpendicular angle. The particle bombardment renders those areas of the dye suspension material left exposed by the mask relatively impervious to developing agents. In this embodiment, the selected dye suspension material itself must additionally be unusually resistant to damage by the particle bombardment so that such exposure does not result in altered wavelength response. The areas of the dye suspension left unexposed to the particle bombardment and the photoresist are removed by development, leaving the exposed areas as the desired filter elements.

In the previous two methods, the chemistry of the patterning photoresist process is such that the photoresist stripping step does not affect the underlying polymer layer. For example, a water-soluble resist on a solvent-soluble polymer can be used.

In a third embodiment, to avoid complications due to the chemistry of the patterning photoresist, a photolithographic process is not used at all. The dye suspension is formed in a layer over the surface of the support structure. The filter elements are formed through particle bombardment rastering which defines the filter boundaries. The exposed areas are removed leaving the desired filter.

In a fourth embodiment, particle bombardment rastering is again used to form the desired filter elements except a negative system is used. Those areas exposed to the rastered particle bombardment are rendered insoluble to developing agents and the unexposed areas are chemically removed.

The process may be repeated to create multiple layers of filter elements. Typically, the process is repeated three times to create red, green and blue filter layers. Adhesion promoter layers are used to separate the different layers. The adhesion promoter layers further provide a planarized surface for depositing the subsequent layer of filter elements and protect previously patterned filter elements from subsequent particle bombardments.

Through the proper selection of the particle bombardment process (using either ions or electrons) and the materials used, two important advantages are achieved. First, the particle bombardment creates edges on the filter elements which are more precisely defined and thus which more closely match their corresponding sensor element. Second, the particle bombardment technique eliminates problems of the interdependency of light waveband necessary to change the chemistry of the photoresist on the one hand, and the necessary passband characteristics of the filter elements on the other. Often, these two requirements are in conflict. Third, the complexity of the color filter element fabrication process is reduced and a high level of uniformity and degree of control during the manufacturing process is achieved.

### BRIEF DESCRIPTION OF THE DRAWINGS

Further aspects of the invention and their advantages will be more completely understood by studying the detailed description below, taken in conjunction with the appended drawings in which like numbers identify like parts and in which:
FIGURES 1 and 2 are highly magnified elevational sectional views showing successive steps in the fabrication of an electromagnetic filter layer, certain dimensions thereof being exaggerated for the purpose of clarity;
FIGURES 3 and 4 are highly magnified elevational sectional views showing successive steps in the fabrication of an electromagnetic filter layer in a negative system;
FIGURES 5 and 6 are highly magnified elevational sectional views showing successive steps in the fabrication of an electromagnetic filter layer in a positive rastered particle bombardment system;
FIGURES 7 and 8 are highly magnified elevational sectional views showing successive steps in the fabrication of an electromagnetic filter layer in a negative rastered particle bombardment system; and
FIGURE 9 is a highly magnified elevational sectional view of a semiconductor receptor with several layers of electromagnetic filter elements formed at its face.

### DETAILED DESCRIPTION OF THE INVENTION

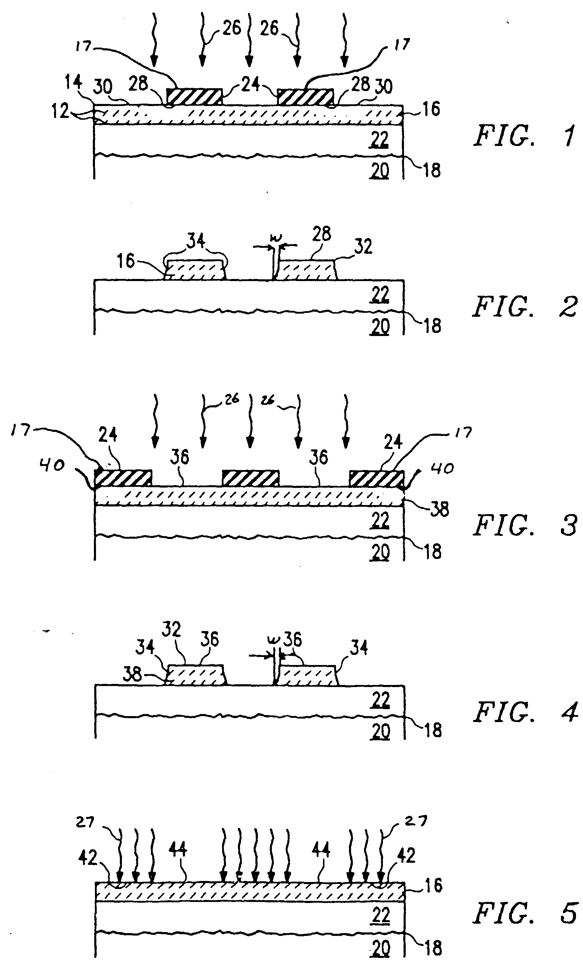

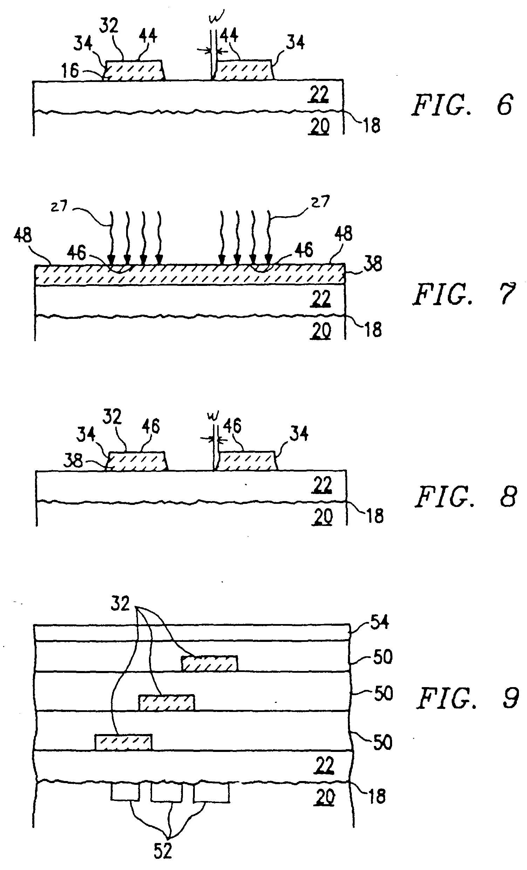

Part of a first exemplary method for the fabrication of an electromagnetic filter according to the invention is shown in FIGURES 1 and 2.

A dye 12 is selected for its ability to transmit incident electromagnetic radiation of a desired wavelength and block at least some electromagnetic radiation of undesirable wavelengths. Dye 12 is a solvent dye, soluble for example in metaxylene. Typically, in optical applications, dye 12 is selected to transmit wavelengths corresponding to one of the red (around 650 nanometres), green (around 530 nanometres), and blue (around 440 nanometres) portions of the optical spectrum.

Base material 14 is selected for its ability to suspend dye 12 without thermal or chemical damage, i.e, the base material will not react with the dye in a destructive manner within those environments in which the completed device is designed to operate. Further, base material 14 must be non-opaque to the selected wavelength to be filtered. In a preferred embodiment, the base material 14 is polymethyl methacrylate (PMMA).

Dye 12 is suspended in base material 14 to create a composite 16. In the preferred embodiment, dye 12 and base material 14 are chosen such that composite 16 is used in a positive acting system. In this system of processing, areas of composite 16 exposed to particle bombardment are rendered soluble during subsequent chemical development, while the masked areas remain undamaged by the particles.

The surface 18 of semiconductor sensor 20 is prepared by depositing and hard baking thereon a layer 22 of planarization material. Layer 22 could be, for example, formed of a polyimide and could also be patterned to open specified regions on the device, such as bonding pads. Layer 22 protects semiconductor sensor 20 from exposure during subsequent particle bombardment. Following the baking on of layer 22, a layer 16 of composite material is then deposited across layer 22 and then also baked. Preferably, baking consists of exposure at 125°C for thirty minutes. A layer 24 of positive acting photoresist is then deposited on composite layer 16. The photoresist layer 24 is then selectively exposed, for example, to ultraviolet light in a conventional process step, and developed to leave only non-exposed regions 17 of photoresist on layer 16. The chemistry of the photoresist is based, for example, on water-soluble materials so as not to dissolve the dyed polymer, whose chemistry is organic solvent based.

Particle bombardment, represented in FIGURE 1 by wavy lines at 26, is directed at a substantially perpendicular angle to the developed photoresist layer 24 (covering regions 28 of composite 16) and to exposed regions 30 of composite 16. Typically, particle bombardment 26 comprises exposure to electrons moving under the influence of an electric field, but other charged particles such as ions can also be used. Particle bombardment 26 however does not consist of mere exposure to electromagnetic radiation.

Following particle bombardment 26, in the illustrated positive acting system, exposed areas 30 of composite material 16, delineated by dotted lines, are removed through chemical development. An example development system uses a metaxylene solvent system. Photoresist pattern 24 is then stripped leaving unexposed areas 28 of composite material 16.

The resulting filter element layer is shown generally at 32 in FIGURE 2. Since particle bombardment 26 impinges upon photoresist pattern 24 and exposed areas 30 at a substantially perpendicular angle, the resulting transition regions or sidewalls 34 of filter elements 32 are sharply defined, with widths of less than two micrometers. Further, particle bombardment 26 retains the integrity of dye 12 in composite 16 since dye 12 itself is light sensitive and can be damaged during standard optical photoresist processing.

In a second exemplary method a negative acting system is used. This process is shown in FIGURES 3 and 4. This process is similar to that described above for the preferred embodiment, except that dye 13 and base material 15 are chosen such that particle bombardment 26 renders exposed areas 36 of negative acting composite 38 insoluble to chemical development while unexposed areas 40 remain soluble. An example of a base material 15 for using in a negative acting system is styrene butadiene copolymer. Areas 40 of composite 38 kept unexposed by the photoresist mask 24 are removed during chemical development, which result in the exposed areas 36 being left as the desired filter elements.

In a third exemplary method, photolithographic processing is not used, but rather the filter elements are defined by a rastering particle bombardment 27. This process is shown generally for a positive acting system in FIGURES 5 and 6.

Particle bombardment 27 is selectively directed at a layer of positive acting composite 16 to define boundaries of the filter elements. The exposed areas 42 are rendered soluble to chemical development, and subsequently chemically removed leaving unexposed areas 44 as the filter elements.

In a fourth exemplary method a negative acting system using particle bombardment rastering is used. This process is shown generally in FIGURES 7 and 8. Negative acting composite 38 is layered over surface 18. Particle bombardment is rastered to render exposed areas 46 insoluble to chemical development and therefore remain as the desired filter elements when the unexposed regions 48 are chemically removed.

FIGURE 9 shows multilayers of filter elements 32 formed through repeat processing. Planarization and adhesion layers 50 are formed to first, provide a flat surface on which additional filter elements 32 may be formed, and second, to protect already formed filter elements 32 from the subsequent particle bombardment during repeat processing. Planarization layers 50, which for example are composed of polyimide, are non-opaque to the wavelength transmitted by the previously formed underlying filter element 32, and are patterned to be open in certain device areas such as bonding pads (not shown). Filter elements 32 are formed aligned with receptor elements 52 in semiconductor sensor 20. Finally, a non-opaque protective coat 54, which may also be for example a polyimide, is created across the entire structure for additional protection. During the process steps, apertures are left through each of the planarization layers on the periphery of the array to allow access to bonding pads (not shown). It is therefore desirable that the material chosen for the planarization layers 50 be itself a photosensitive material such as photosensitive polyimide which is easily patterned to be open at desired areas.

In summary, electromagnetic filter elements 32 with sharply defined boundaries are efficiently created at the face of a semiconductor sensor 20. Additionally, through maintaining integrity of the dye 12 suspended in the solid 14, the transmission band of each filter element 32 can be more accurately controlled. These are significant advantages which set these filter elements apart from those of the prior art.

While preferred embodiments of the present invention and its advantages have been described in the above detailed description, the invention is not limited thereto, but only by the scope and spirit of the appended claims.

## Claims

1. An electromagnetic radiation filter element comprising:
a first radiation-transmitting solid formed on a supporting structure, said supporting structure being operable to receive radiation as filtered by said solid, said first radiation-transmitting solid being a particle beam resist, a bottom face of said solid being adjacent said supporting structure, a top face of said solid being remote from said supporting structure;
a first solvent dye suspended in said solid for filtering radiation of first wavelengths;
sidewalls of said first solid extending from said top face to said bottom face, a slope of said sidewalls being such that, at each sidewall, said bottom face extends laterally outwardly beyond said top face by an amount no greater than two micrometer;
a planarization layer over said first solid;
a second radiation-transmitting solid of a particle beam resist material over said planarization layer; and
a second solvent dye suspended in said second solid for filtering radiation of second wavelengths.

2. The element of Claim 1, wherein said solid comprises an organic polymer.

3. The element of Claim 2, wherein said solid is polymethyl methacrylate.

4. The element of Claim 1, wherein said supporting structure comprises a face of an electromagnetic radiation receptor.

5. The element of Claim 4, wherein said filter is formed at the face of a semiconductor receptor.

6. The element of Claim 5, wherein said receptor is an imager.

7. The element of Claim 6, wherein said imager is sensitive to visible light.

8. The element of Claim 1, wherein said support structure comprises a plurality of imager cells, a plurality of said elements being aligned with corresponding imager cells.

9. The element of Claim 1, and further comprising a planarization layer formed adjacent to said support structure, said solid being formed on said planarization layer.

10. A method for fabricating an electromagnetic radiation filter element as claimed in claim 1 comprising:
forming the first layer of particle beam resist with the first solvent dye suspended therein over a surface of the supporting structure;
patterning the first particle beam resist layer by exposure to particle bombardment;
forming the planarization layer over the first particle beam resist layer; and
forming, over the planarization layer, the second layer of particle beam resist with the second solvent dye suspended therein.

11. The method of claim 10, wherein the forming of the first layer of particle beam resist comprises:
suspending the first dye in particle beam resist; and
depositing a layer of the resultant material.

12. The method of claim 10 or claim 11, wherein the patterning comprises:
forming a patterned mask of photoresist over the first layer of particle beam resist;
exposing the first layer of particle beam resist to particle bombardment through the mask; and
developing the first layer of particle beam resist.

13. The method of claim 10 or claim 11, wherein the patterning comprises:
selectively exposing portions of the first layer of particle beam resist to particle bombardment, and
developing the layer of first particle beam resist.

14. The method of claim 12 or claim 13, wherein developing removes the portions of the first layer of particle beam resist exposed to particle bombardment.

15. The method of claim 12 or claim 13, wherein developing removes the portions of the first layer of particle beam resist not exposed to particle bombardment.

16. The method of any one of claims 10 to 15, wherein the first or second layer of particle beam resist is capable of suspending its dye without chemical or thermal damage in environments in which the electromagnetic filter will be placed while in use.

17. The method of any one of claims 10 to 16, wherein the wavelength filtered by the first or second layer of particle beam resist comprises a portion of the optical region of the electromagnetic radiation spectrum.

18. The method of any one of claims 10 to 17, wherein said filter is formed at the face of a semiconductor layer.

19. The method of claim 18, wherein said filter is an on chip colour filter.

20. The method of any one of claims 10 to 19, wherein the first layer of particle beam resist is formed on a planarization layer.

21. The method of any one of claims 10 to 20 comprising:
forming a planarization layer over the second layer of particle beam resist,
forming, over that planarization layer, a third layer of particle beam resist with a third solvent dye suspended therein.

22. The method of any one of claims 10 to 21 comprising:
forming a protective overcoat across the surface of said filter element.

## Patentansprüche

1. Filterelement für elektromagnetische Strahlung, mit:
einem ersten strahlungsübertragenden Festkörper, der auf einer Trägerstruktur gebildet ist, wobei die Trägerstruktur durch den Festkörper gefilterte Strahlung empfangen kann, wobei der erste strahlungsübertragende Festkörper ein Teilchenstrahlresist ist, wobei eine Unterfläche des Festkörpers an die Trägerstruktur angrenzt und eine obere Fläche des Festkörpers von der Trägerstruktur entfernt liegt;
einem ersten Lösungsmittelfarbstoff, der in dem Festkörper zum Filtern von Strahlung erster Wellenlängen suspendiert ist;
Seitenwänden des ersten Festkörpers, die sich von der oberen Fläche zu der unteren Fläche erstrecken, wobei eine Neigung der Seitenfläche derart ist, daß die untere Fläche an jeder Seitenwand seitlich nach außen über die obere Fläche um einen Wert vorsteht, der nicht größer als zwei µm ist;
einer Planarisierungsschicht über dem ersten Festkörper;
einem zweiten strahlungsübertragenden Festkörper aus einem Teilchenstrahlresistmaterial über der Planarisierungsschicht; und
einem zweiten Lösungsmittelfarbstoff, der zum Filtern von Strahlung mit zweiten Wellenlängen in den zweiten Festkörper suspendiert ist.

2. Element nach Anspruch 1, bei welchem der Festkörper ein organischer Polymer ist.

3. Element nach Anspruch 2, bei welchem der Festkörper Polymethylmethacrylat ist.

4. Element nach Anspruch 1, bei welchem die Trägerstruktur eine Fläche eines Empfängers für elektromagnetische Strahlung ist.

5. Element nach Anspruch 4, bei welchem das Filter an der Fläche eines Halbleiterempfängers gebildet ist.

6. Element nach Anspruch 5, bei welchem der Empfänger ein Bilderzeuger ist.

7. Element nach Anspruch 6, bei welchem der Bilderzeuger für sichtbares Licht empfindlich ist.

8. Element nach Anspruch 1, bei welchem die Trägerstruktur mehrere Bilderzeugerzellen enthält, wobei mehrere Elemente mit entsprechenden Bilderzeugerzellen in einer Linie liegen.

9. Element nach Anspruch 1, ferner enthaltend eine Planarisierungsschicht, die angrenzend an die Trägerstruktur gebildet ist, wobei der Festkörper auf der Planarisierungsschicht gebildet ist.

10. Verfahren zum Herstellen eines Filterelements für elektromagnetische Strahlung nach Anspruch 1, bei welchem:
die erste Schicht aus dem Teilchenstrahlresist mit dem darin suspendierten Lösungsmittelfarbstoff über einer Fläche der Trägerstruktur gebildet wird;
die erste Schicht aus dem Teilchenstrahlresist durch Aussetzen eines Beschusses mit Teilchen strukturiert wird;
die Planarisierungsschicht über der ersten Schicht aus dem Teilchenstrahlresist gebildet wird; und
über der Planarisierungsschicht die zweite Schicht aus dem Teilchenstrahlresist mit dem darin suspendierten zweiten Lösungsmittelfarbstoff gebildet wird.

11. Verfahren nach Anspruch 10, bei welchem das Bild in der ersten Schicht aus dem Teilchenstrahlresist umfaßt:
Suspendieren des ersten Farbstoffs in dem Teilchenstrahlresist; und
Aufbringen einer Schicht aus dem resultierenden Material.

12. Verfahren nach Anspruch 10 oder Anspruch 11, bei welchem das Strukturieren umfaßt:
Bilden einer strukturierten Photoresistmaske über der ersten Schicht aus dem Teilchenstrahlresist;
Aussetzen der ersten Schicht aus dem Teilchenstrahlresist einem Teilchenbeschuß durch die Maske; und
Entwickeln der ersten Schicht aus dem Teilchenstrahlresist.

13. Verfahren nach Anspruch 10 oder Anspruch 11, bei welchem das Strukturieren umfaßt:
selektives Aussetzen von Abschnitten der ersten Schicht aus dem Teilchenstrahlresist einem Teilchenbeschuß, und
Entwickeln der Schicht aus dem ersten Teilchenstrahlresist.

14. Verfahren nach Anspruch 12 oder Anspruch 13, bei welchem das Entwickeln die dem Teilchenbeschuß ausgesetzten Abschnitte der ersten Schicht aus dem Teilchenstrahlresist entfernt.

15. Verfahren nach Anspruch 12 oder Anspruch 13, bei welchem das Entwickeln die dem Teilchenbeschuß nicht ausgesetzten Abschnitte der ersten Schicht aus dem Teilchenstrahlresist entfernt.

16. Verfahren nach einem der Ansprüche 10 bis 15, bei welchem die erste oder die zweite Schicht aus dem Teilchenstrahlresist ihren Farbstoff ohne chemische oder thermische Beschädigung in Umgebungen suspendieren kann, in denen das elektromagnetische Filter während der Benutzung angebracht wird.

17. Verfahren nach einem der Ansprüche 10 bis 16, bei welchem die durch die erste oder zweite Schicht aus dem Teilchenstrahlresist gefilterte Wellenlänge einen Abschnitt des optischen Bereichs des elektromagnetischen Strahlungsspektrums umfaßt.

18. Verfahren nach einem der Ansprüche 10 bis 17, bei welchem das Filter an der Fläche einer Halbleiterschicht gebildet wird.

19. Verfahren nach Anspruch 18, bei welchem das Filter ein Farbfilter auf einem Chip ist.

20. Verfahren nach einem der Ansprüche 10 bis 19, bei welchem die erste Schicht aus dem Teilchenstrahlresist auf einer Planarisierungsschicht gebildet wird.

21. Verfahren nach einem der Ansprüche 10 bis 20, bei welchem:
über der zweiten Schicht aus dem Teilchenstrahlresist eine Planarisierungsschicht gebildet wird,
über der Planarisierungsschicht eine dritte Schicht aus dem Teilchenstrahlresist mit einem darin suspendierten dritten Lösungsmittelfarbstoff gebildet wird.

22. Verfahren nach einem der Ansprüche 10 bis 21, bei welchem: über der Fläche des Filterelements ein Schutzüberzug gebildet wird.

## Revendications

1. Elément de filtre pour rayonnement électromagnétique comprenant :
un premier solide de transmission du rayonnement formé sur une structure de support, ladite structure de support pouvant agir de manière à recevoir un rayonnement tel qu'il est filtré par ledit solide, ledit premier solide de transmission du rayonnement étant un résist à un faisceau de particules, une face inférieure du solide étant adjacente à ladite structure de support, et une face supérieure dudit solide étant éloignée de ladite structure de support ;
un premier colorant à solvant en suspension dans ledit solide pour filtrer le rayonnement ayant des premières longueurs d'onde ;
des parois latérales dudit premier solide s'étendant depuis ladite face supérieure jusqu'à ladite face inférieure, une inclinaison desdites parois latérales étant telle qu'au niveau de chaque paroi latérale, ladite face inférieure s'étend latéralement vers l'extérieur au-delà de ladite face supérieure et ce sur une distance non supérieure à deux microns ;
une couche de planarisation située au-dessus dudit premier solide ;
un second solide de transmission du rayonnement formé d'un matériau de résist à un faisceau de particules, au-dessus de ladite couche de planarisation ; et
un second colorant à solvant en suspension dans ledit second solide pour filtrer le rayonnement ayant des secondes longueurs d'onde.

2. Elément selon la revendication 1, dans lequel ledit solide comprend un polymère organique.

3. Elément selon la revendication 2, dans lequel ledit solide est du polyméthylméthacrylate.

4. Elément selon la revendication 1, dans lequel ladite structure de support comporte une face d'un récepteur de rayonnement électromagnétique.

5. Elément selon la revendication 4, dans lequel ledit filtre est formé sur la face d'un récepteur à semiconducteur.

6. Elément selon la revendication 5, dans lequel ledit récepteur est un imageur.

7. Elément selon la revendication 6, dans lequel ledit imageur est sensible à la lumière visible.

8. Elément selon la revendication 1, dans lequel ladite structure de support comporte une pluralité de cellules d'imageur, une pluralité desdits éléments étant alignés avec des cellules d'imageur correspondantes.

9. Elément selon la revendication 1, comprenant en outre une couche de planarisation formée au voisinage de ladite structure de support, ledit solide étant formé sur ladite couche de planarisation.

10. Procédé pour fabriquer un élément de filtre pour rayonnement électromagnétique tel que défini dans la revendication 1, comprenant :
la formation de la première couche de résist à un faisceau de particules, contenant le premier colorant à solvant en suspension, sur une surface de la structure de support ;
la structuration de la première couche de résist à un faisceau de particules, par exposition à un bombardement par les particules ;
la formation de la couche de planarisation au-dessus de la première couche de résist au faisceau de particules ; et
la formation, sur la couche de planarisation, de la seconde couche de résist au faisceau de particules, contenant le second colorant à solvant en suspension.

11. Procédé selon la revendication 10, selon lequel la formation de la première couche de résist au faisceau de particules comprend :
la mise en suspension du premier colorant dans le résist au faisceau de particules ; et
le dépôt d'une couche du matériau résultant.

12. Procédé selon la revendication 10 ou 11, selon lequel la structuration comprend :
la formation d'un masque structuré de photorésist sur la première couche de résist au faisceau de particules ;
l'exposition de la première couche de résist au faisceau de particules à un bombardement de particules à travers le masque ; et
le développement de la première couche de résist au faisceau de particules.

13. Procédé selon la revendication 10 ou 11, selon lequel la structuration comprend :
l'exposition sélective de parties de la première couche de résist au faisceau de particules à un bombardement de particules, et
le développement de la couche du premier résist au faisceau de particules.

14. Procédé selon la revendication 12 ou 13, selon lequel le développement élimine les parties de la première couche de résist au faisceau de particules, exposée à un bombardement par les particules.

15. Procédé selon la revendication 12 ou 13, selon lequel le développement élimine des parties de la première couche de résist au faisceau de particules, non exposées au bombardement par des particules.

16. Procédé selon l'une quelconque des revendications 10 à 15, selon lequel la première ou seconde couche de résist au faisceau de particules est à même de mettre en suspension son colorant sans endommagement chimique ou thermique des environnements, dans lesquels le filtre électromagnétique est placé lors de son utilisation.

17. Procédé selon l'une quelconque des revendications 10 à 16, selon lequel la longueur d'onde filtrée par la première ou la seconde couche de résist au faisceau de particules comprend une partie de la région optique du spectre de rayonnement électromagnétique.

18. Procédé selon l'une quelconque des revendications 10 à 17, selon lequel ledit filtre est formé sur la face d'une couche de semiconducteur.

19. Procédé selon la revendication 18, selon lequel ledit filtre est un filtre coloré sur puce.

20. Procédé selon l'une quelconque des revendications 10 à 19, selon lequel la première couche de résist au faisceau de particules est formée sur une couche de planarisation.

21. Procédé selon l'une quelconque des revendications 10 à 20, comprenant :
la formation d'une couche de planarisation au-dessus de la seconde couche de résist au faisceau de particules,
la formation, au-dessus de cette couche de planarisation, d'une troisième couche de résist au faisceau de particules dans laquelle est en suspension un troisième colorant à solvant.

22. Procédé selon l'une quelconque des revendications 10 à 21, comprenant :
la formation d'un revêtement protecteur sur la surface dudit élément de filtre.
